(19) **Europäisches Patentamt**
**European Patent Office**
**Office européen des brevets**

(11) **EP 4 772 899 A1**

(12) **EUROPEAN PATENT APPLICATION**
published in accordance with Art. 153(4) EPC

(43) Date of publication:
**08.07.2026  Bulletin 2026/28**

(21) Application number: **25869598.0**

(22) Date of filing: **08.08.2025**

(51) International Patent Classification (IPC):
**G01R 31/389** (2019.01)   **G01R 31/387** (2019.01)
**G01R 31/396** (2019.01)   **G01R 31/392** (2019.01)
**G01R 31/367** (2019.01)   **G01R 35/00** (2006.01)
**G01R 19/165** (2006.01)   **H02J 7/00** (2026.01)

(52) Cooperative Patent Classification (CPC):
**G01R 19/165; G01R 31/367; G01R 31/387;**
**G01R 31/389; G01R 31/392; G01R 31/396;**
**G01R 35/00; H02J 7/00**

(86) International application number:
**PCT/KR2025/012026**

(87) International publication number:
**WO 2026/079621 (16.04.2026 Gazette 2026/16)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority:  **08.10.2024  KR 20240136393**

(71) Applicant: **LG Energy Solution, Ltd.**
**Seoul 07335 (KR)**

(72) Inventors:
• **CHO, Inhwan**
  **Daejeon 34122 (KR)**
• **LEE, Dajin**
  **Daejeon 34122 (KR)**
• **KIM, Ju Young**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **METHOD AND APPARATUS FOR DIAGNOSING BATTERY CELL**

(57)     A diagnosis apparatus of a battery cell sets an
SOC of a battery cell through charging, stores SOC
setting data immediately after setting the SOC, measures
an impedance of the battery cell, corrects the impedance
based on the SOC setting data to calculate a corrected
impedance, and diagnoses a low-voltage defect of the
battery cell based on the corrected impedance.

FIG. 5

**Description**

[Technical Field]

CROSS-REFERENCE TO RELATED APPLICATION

This application claims priority to and the benefit of Korean Patent Application No. 10-2024-0136393 filed in the Korean Intellectual Property Office on October 8, 2024, the entire contents of which are incorporated herein by reference.
The disclosure relates to a diagnosis method of a battery cell and a diagnosis apparatus of a battery cell.

[Background Art]

Electric vehicles or hybrid vehicles are automobiles that obtain power by driving a motor mainly using a battery as a power source, and research is being actively conducted as they are an alternative that can solve the pollution and energy problems of internal combustion automobiles. Furthermore, rechargeable batteries are used in various external apparatuses other than the electric vehicles.
In a battery cell manufacturing process, a short circuit may occur in a battery cell due to reasons such as a defective separator or introduction of a metallic foreign object, which can cause a low-voltage defect where the battery cell exhibits more self-discharge compared to a normal cell. A battery cell with a low level of short circuit may have a possibility of being shipped without being detected during an open circuit voltage (OCV) tracking process.

[Disclosure]

[Technical Problem]

Some embodiments may provide a method and apparatus for diagnosing of a battery cell, which can detect a low-voltage defect.

[Technical Solution]

According to some embodiments, a diagnosis method of a battery cell may be provided. The diagnosis method may include setting a state of charge (SOC) of the battery cell through charging, storing SOC setting data immediately after setting the SOC, measuring an impedance of the battery cell, correcting the impedance based on the SOC setting data to calculate a corrected impedance, and diagnosing a low-voltage defect of the battery cell based on the corrected impedance.
According to some embodiments, a diagnosis apparatus of a battery cell may include a charger/discharger, an electrochemical impedance spectroscopy (EIS) measurement device, and a processor. The charger/discharger may be configured to set an SOC of the battery cell through charging. The EIS measurement device may be configured to perform an EIS measurement to measure an impedance of the battery cell. The processor may be configured to correct the impedance based on SOC setting data immediately after setting the SOC to calculate a corrected impedance, and to diagnose a low-voltage defect of the battery cell based on the corrected impedance.
According to some embodiments, a computer program executed by a computing device and stored in a recording medium may be provided. The computer program may cause the computing device to execute storing SOC setting data immediately after setting an SOC of a battery cell through charging, correcting an impedance of the battery cell based on the SOC setting data to calculate a corrected impedance, and diagnosing a low-voltage defect of the battery cell based on the corrected impedance.

[Description of the Drawings]

FIG. 1 is a diagram illustrating a diagnosis apparatus of a battery cell according to some embodiments.
FIG. 2 is a flowchart of a diagnosis method of a battery cell according to the prior art.
FIG. 3 is a diagram comparing charging capacities of a low-voltage cell and a normal cell.
FIG. 4 is a diagram comparing voltages of a low-voltage cell and a normal cell.
FIG. 5 is a flowchart of a diagnosis method of a battery cell according to some embodiments.
FIG. 6 is a flowchart of an impedance correction method according to some embodiments.

[Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

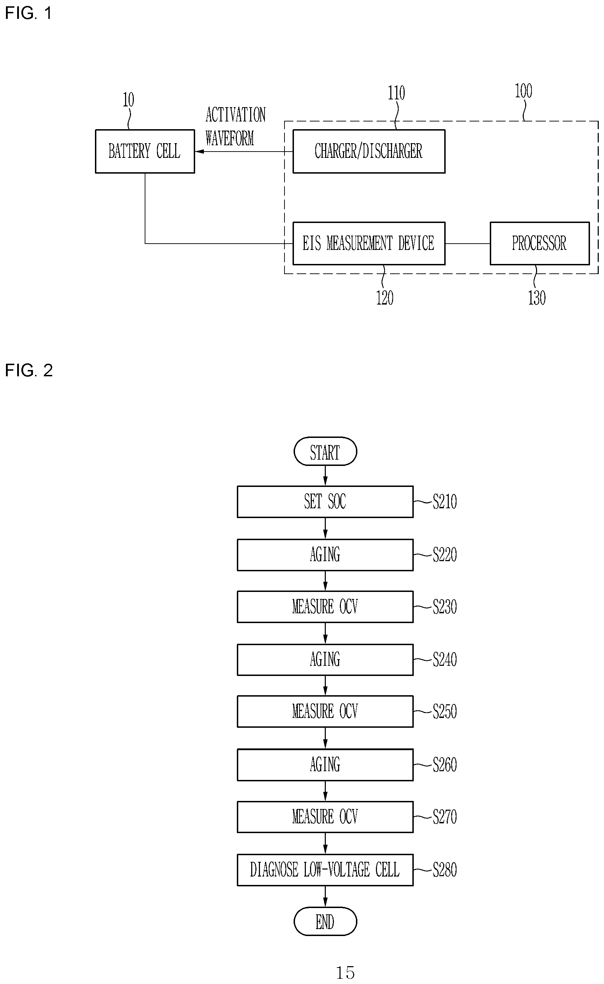

FIG. 1 is a diagram illustrating a diagnosis apparatus of a battery cell according to some embodiments.

Referring to FIG. 1, a diagnosis apparatus 100 may be connected to a battery cell 10, and may diagnose a defective cell in which a low-voltage defect occurs among battery cells 10 during a battery manufacturing process. In some embodiments, the diagnosis apparatus 100 may be connected to the battery cells 10 to diagnose the battery cells 10. In some embodiments, the battery cell 10 may be, for example, a lithium battery such as a lithium-ion battery or a lithium-ion polymer battery.

In some embodiments, the battery manufacturing process may proceed largely through an electrode process, an assembly process, an activation process, and a pack process. The electrode process may be a process of making a positive electrode and a negative electrode of a battery cell, the assembly process may a process of forming a shape of the battery cell, the activation process may be a process of activating and stabilizing electrical energy in the battery cell, and the pack process may be a process of modularizing battery cells. In some embodiments, the activation process may proceed with repeated aging, charging, and discharging. In the aging, the battery cell may be stored at a constant temperature and humidity so that an electrolyte can permeate into the positive electrode and the negative electrode, and when the electrolyte soaks into the inside of the battery cell and ions move smoothly between the positive electrode and the negative electrode, the battery cell may be partially charged. In the activation process, the performance (capacity and impedance) of the battery may be checked by repeating the aging and charging/discharging processes, and a low-voltage cell may be detected through an OCV measurement.

The diagnosis apparatus 100 may include a charger/discharger 110, an electrochemical impedance spectroscopy (EIS) measurement device 120, and a processor 130. In some embodiments, the processor 130 may be provided as a computing device.

In some embodiments, the battery cell 10 may be manufactured by injecting an electrolyte into an electrode assembly that includes a negative electrode, a positive electrode, and a separator. The battery cell 10 may function as a battery through activation by aging and charging/discharging in the activation process. The charger/discharger 110 may charge or discharge the battery cell 10 by applying an activation waveform to the battery cell 10 in the activation process. The activation waveform may be a waveform having an alternating current (AC) voltage of a predetermined frequency. In some embodiments, the charger/discharger 110 may apply the activation waveform to the positive electrode of the battery cell 10 while the negative electrode of the battery cell 10 is connected to a ground terminal. In some embodiments, the charger/discharger 110 may have a plurality of channels to which a plurality of battery cells 10 are respectively connected, and may charge or discharge the plurality of battery cells 10 by applying the activation waveform to each of the plurality of channels.

The EIS measurement device 120 may perform an EIS measurement on the battery cell 10 while the battery cell 10 is being charged or discharged. In some embodiments, the EIS measurement device 120 may perform an in-situ EIS measurement. The EIS measurement device 120 may measure a response of the battery cell 10 while applying the activation waveform, and may measure an impedance of the battery cell 10 based on the activation waveform and the response of the battery cell 10. In some embodiments, the EIS measurement device 120 may measure an AC current response (i.e., output current) of the battery cell 10 while applying the activation waveform of the AC voltage to the battery cell 10, and may measure the impedance of the battery cell 10 based on the AC voltage and the output current. In some embodiments, the EIS measurement device 120 may measure the impedance (e.g., reactance which is an imaginary component of impedance) of the battery cell 10 by determining a phase shift and amplitude change of the output current based on the AC current response.

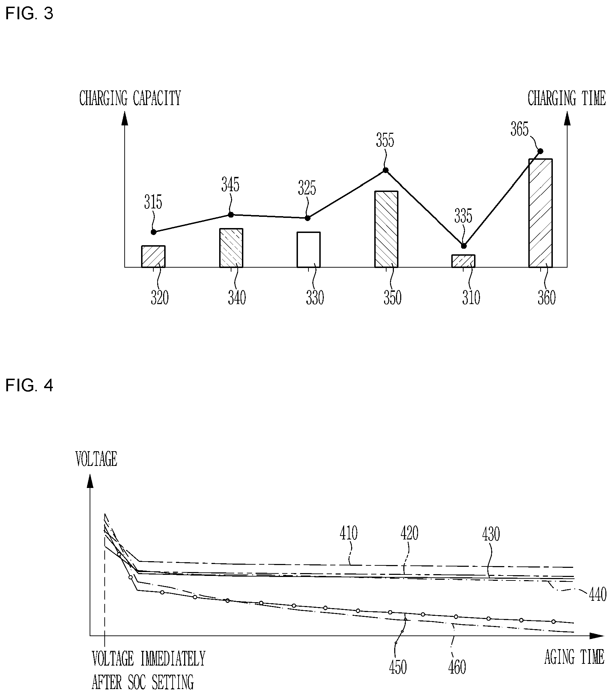

FIG. 2 is a flowchart of a diagnosis method of a battery cell according to the prior art, FIG. 3 is a diagram comparing charging capacities of a low-voltage cell and a normal cell, and FIG. 4 is a diagram comparing voltages of a low-voltage cell and a normal cell.

Referring to FIG. 2, a diagnosis apparatus may set a state of charge (SOC) by charging a battery cell (S210). The diagnosis apparatus may proceed with constant voltage (CV) charging after constant current (CC) charging.

After charging the battery cell, the diagnosis apparatus may repeat aging of the battery cell and an OCV measurement of the battery cell. For example, the diagnosis apparatus may age the battery cell for a first predetermined time (S220) and then measure an OCV of the battery cell (S230). Next, the diagnosis apparatus may age the battery cell for a second predetermined time (S240) and then measure the OCV of the battery cell (S250). Next, the diagnosis apparatus may age the battery cell for a third predetermined time (S260) and then measure the OCV of the battery cell (S270).

After repeating the aging and OCV measurement, the diagnosis apparatus may diagnose whether the battery cell is a low-voltage cell based on the OCV (S280). In this case, the diagnosis apparatus may diagnose whether the battery cell is the low-voltage cell based on a difference between the OCV measured after aging for the first predetermined time and the OCV measured after aging for the third predetermined time. For example, in cases that the OCV difference is greater than a threshold, the diagnosis apparatus may diagnose the corresponding battery cell as the low-voltage cell.

As shown in FIG. 3, in cases of a low-voltage cell with an internal short circuit, self-discharge may occur during the CV charging process. Therefore, due to the self-discharge during the CV charging process, CV charging capacities 340, 350, and 360 of the low-voltage cells may increase compared to CV charging capacities 310, 320, and 330 of normal cells. Similarly, due to the self-discharge, CV charging times 345, 355, and 365 of the low-voltage cells may increase compared to CV charging times 315, 325, and 335 of the normal cells. In this case, the larger the internal short circuit, the larger the CV charging capacity and CV charging time may be.

As shown in FIG. 4, after setting the SOC, the OCV of the battery cell may decrease as time passes. In this case, OCVs 440, 450, and 460 of low-voltage cells may decrease more significantly compared to OCVs 410, 420, and 430 of normal cells. However, in cases of the low-voltage cell, the CV charging capacity and CV charging time may increase, so it may be overcharged compared to the normal cell, and accordingly, the OCV immediately after SOC setting may be measured to be higher than the OCV of the normal cell. Generally, an impedance of the low-voltage cell may be greater than an impedance of the normal cell. However, if the SOC is high (i.e., if the OCV immediately after SOC setting is high), a difference between the impedance of the low-voltage cell and the impedance of the normal cell decreases, so the OCV of the low-voltage cell and the OCV of the normal cell may be measured similarly, making it difficult to detect the low-voltage cell. In particular, as shown in FIG. 4, a low-voltage cell 440 with a small internal short circuit may be difficult to distinguish from normal cells 420 and 430.

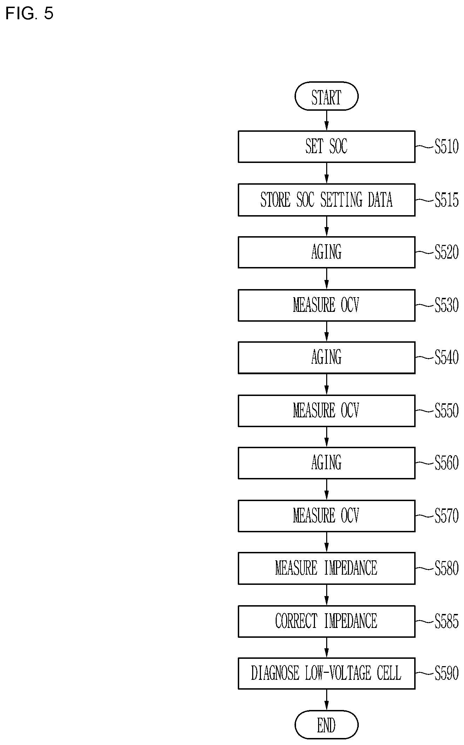

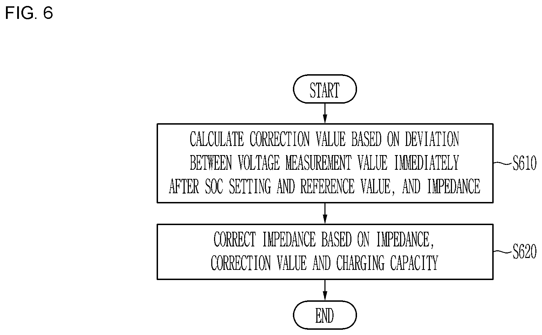

Hereinafter, embodiments that can solve this problem are described with reference to FIG. 5 and FIG. 6.

FIG. 5 is a flowchart of a diagnosis method of a battery cell according to some embodiments, and FIG. 6 is a flowchart of an impedance correction method according to some embodiments.

Referring to FIG. 5, a diagnosis apparatus (e.g., a charger/discharger of the diagnosis apparatus) may set an SOC by charging a battery cell in an activation process (S510). In some embodiments, the diagnosis apparatus may perform CV charging on the battery cell. In some embodiments, the diagnosis apparatus may perform the CV charging after performing CC charging on the battery cell. The diagnosis apparatus (e.g., a processor of the diagnosis apparatus) may store SOC setting data immediately after the SOC setting (S515). In some embodiments, the SOC setting data may include a charging capacity during the charging of the battery cell and a voltage of the battery cell immediately after the SOC setting. In some embodiments, the charging capacity may be a charging capacity during the CV charging, i.e., a CV charging capacity, and the voltage of the battery cell may be an OCV of the battery cell.

After charging the battery cell, the diagnosis apparatus may repeat aging of the battery cell and voltage measurement of the battery cell in the activation process. In some embodiments, the voltage of the battery cell may be the OCV of the battery cell. For example, the diagnosis apparatus may age the battery cell for a first predetermined time (S520) and then measure the OCV of the battery cell (S530). Next, the diagnosis apparatus may age the battery cell for a second predetermined time (S540) and then measure the OCV of the battery cell (S550). Next, the diagnosis apparatus may age the battery cell for a third predetermined time (S560) and then measure the OCV of the battery cell (S570).

The diagnosis apparatus (e.g., an EIS measurement device of the diagnosis apparatus) may measure an impedance of the battery cell (S580). In some embodiments, the diagnosis apparatus may measure the impedance of the battery cell through an EIS measurement (S580). For this, the battery apparatus may measure a response of the battery cell while applying an activation waveform (e.g., an activation waveform having an AC voltage) to the battery cell 10, and may measure the impedance of the battery cell based on the activation waveform and the response of the battery cell. In some embodiments, the diagnosis apparatus may measure an AC current response (i.e., output current) of the battery cell while applying the activation waveform having the AC voltage to the battery cell 10, and may measure the impedance of the battery cell based on the AC voltage and the output current. In some embodiments, the diagnosis apparatus may measure the impedance of the battery cell by determining a phase shift and amplitude change of the output current based on the AC current response. In some embodiments, the diagnosis apparatus may measure the impedance in an EOL (end of line) process of the activation process.

The diagnosis apparatus (e.g., the processor of the diagnosis apparatus) may correct the measured impedance (S585). In some embodiments, the diagnosis apparatus may correct the impedance based on the SOC setting data (S585). That is, the diagnosis apparatus may eliminate the effect of a high SOC (or a high voltage immediately after SOC setting) due to overcharge in the low-voltage cell, by correcting the impedance of the battery cell to an impedance under the same SOC setting condition.

In some embodiments, as shown in FIG. 6, the diagnosis apparatus may calculate a correction value based on the voltage (e.g., OCV) of the battery cell measured immediately after SOC setting (referred to as a "voltage measurement value immediately after SOC setting") (S610), and may correct the impedance based on the correction value and the charging capacity (e.g., CV charging capacity) (S620).

In some embodiments, the diagnosis apparatus may calculate the correction value by multiplying the impedance by a deviation between the voltage measurement value immediately after SOC setting and a reference value (i.e., a reference voltage), as in Equation 1 (S610). The reference value may be, for example, an average value of voltages of normal cells measured immediately after SOC setting. In Equation 1, the impedance is impedance per mV, and may be a value obtained by dividing the measured impedance by a voltage at the time of the EIS measurement.

Equation 1 correction value = (impedance / voltage at the time of EIS measurement) × (reference value - voltage measurement value immediately after SOC setting))

Equation 1

In some embodiments, the diagnosis apparatus may correct the impedance by multiplying the impedance by a value obtained by adding 1 to a product of the correction value and the charging capacity, as in Equation 2.

## Equation 2

$$\text{corrected impedance} = \text{impedance} \times (1 + \text{correction value} \times \text{charging capacity})$$

The diagnosis apparatus (e.g., the processor of the diagnosis apparatus) may determine whether the corresponding battery cell is a low-voltage cell based on the corrected impedance (S590). In some embodiments, in cases that the corrected impedance of a target battery cell is greater than a threshold, the diagnosis apparatus may determine the target battery cell as the low-voltage cell (S590).

As described above, the diagnosis apparatus may eliminate the effect of the high SOC (or high voltage immediately after SOC setting) due to overcharge in the low-voltage cell, by correcting the impedance of the battery cell to the impedance under the same SOC setting condition. Accordingly, the low-voltage cell can be accurately detected.

In some embodiments, the diagnosis apparatus may perform the diagnosis method described above in a process other than the activation process. In some embodiments, the diagnosis apparatus may perform the diagnosis method described above on a battery cell that has been stored in stock for a certain period (e.g., 3 months or more) after its manufacture. In some embodiments, the diagnosis apparatus may perform the diagnosis method described above on a battery cell returned from a customer.

In some embodiments, a computing device (or a processor) may perform operations for a computer program for executing the diagnosis method described above. The computer program for executing the diagnosis method may be loaded into a memory. The computer program may include instructions that cause the computing device to perform the diagnosis method when loaded into the memory. In some embodiments, the computer program may cause the computing device to execute storing SOC setting data immediately after setting the SOC of the battery cell through charging; correcting the impedance of the battery cell based on the SOC setting data to calculate a corrected impedance, and diagnosing the low-voltage defect of the battery cell based on the corrected impedance.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

**Claims**

1. A diagnosis method of a battery cell, comprising:

   setting a state of charge (SOC) of the battery cell through charging;
   storing SOC setting data immediately after setting the SOC;
   measuring an impedance of the battery cell;
   correcting the impedance based on the SOC setting data to calculate a corrected impedance; and

diagnosing a low-voltage defect of the battery cell based on the corrected impedance.

2. The diagnosis method of claim 1, wherein the SOC setting data comprises a charging capacity during the charging and a voltage of the battery cell immediately after setting the SOC.

3. The diagnosis method of claim 2, wherein calculating the corrected impedance comprises:

    calculating a correction value based on the voltage of the battery cell immediately after setting the SOC; and correcting the impedance based on the correction value and the charging capacity.

4. The diagnosis method of claim 3, wherein calculating the correction value comprises calculating the correction value based on a difference between the voltage of the battery cell immediately after setting the SOC and a reference voltage, and the impedance.

5. The diagnosis method of claim 4, wherein calculating the correction value comprises calculating the correction value by the following equation:

    the correction value = (the impedance / voltage at a time of impedance measurement) $\times$ (the reference voltage - the voltage of the battery cell immediately after setting the SOC).

6. The diagnosis method of claim 3, wherein correcting the impedance comprises correcting the impedance by the following equation:
    the corrected impedance = the impedance $\times$ (1 + the correction value $\times$ the charging capacity).

7. The diagnosis method of claim 1, further comprising repeating aging of the battery cell and an open circuit voltage (OCV) measurement of the battery cell, before measuring the impedance of the battery cell.

8. The diagnosis method of claim 1, wherein measuring the impedance comprises measuring the impedance by an electrochemical impedance spectroscopy (EIS) measurement.

9. The diagnosis method of claim 1, wherein the charging comprises a constant voltage (CV) charging.

10. A diagnosis apparatus of a battery cell, comprising:

    a charger/discharger configured to set a state of charge (SOC) of the battery cell through charging;
    an electrochemical impedance spectroscopy (EIS) measurement device configured to perform an EIS measurement to measure an impedance of the battery cell; and
    a processor configured to correct the impedance based on SOC setting data immediately after setting the SOC to calculate a corrected impedance, and to diagnose a low-voltage defect of the battery cell based on the corrected impedance.

11. The diagnosis apparatus of claim 10, wherein the SOC setting data comprises a charging capacity during the charging and a voltage of the battery cell immediately after setting the SOC.

12. The diagnosis apparatus of claim 11, wherein the processor is further configured to calculate a correction value based on the voltage of the battery cell immediately after setting the SOC, and to correct the impedance based on the correction value and the charging capacity.

13. The diagnosis apparatus of claim 12, wherein the processor is further configured to calculate the correction value based on a difference between the voltage of the battery cell immediately after setting the SOC and a reference voltage, and the impedance.

14. The diagnosis apparatus of claim 13, wherein the processor is further configured to calculate the correction value by the following equation:

the correction value = (the impedance / (voltage at a time of impedance measurement)) × (the reference voltage - the voltage of the battery cell immediately after setting the SOC).

15. The diagnosis apparatus of claim 12, wherein the processor is further configured to correct the impedance by the following equation:

the corrected impedance = the impedance × (1 + the correction value × the charging capacity).

16. A computer program stored in a recording medium and executed by a computing device, wherein the computer program causes the computing device to execute:

storing state of charge (SOC) setting data immediately after setting an SOC of a battery cell through charging;
correcting an impedance of the battery cell based on the SOC setting data to calculate a corrected impedance; and
diagnosing a low-voltage defect of the battery cell based on the corrected impedance.

FIG. 1

FIG. 2

15

FIG. 3

CHARGING CAPACITY          CHARGING TIME

315   345   325   355   335   365

320   340   330   350   310   360

FIG. 4

VOLTAGE

410   420   430

440

450   460    AGING TIME

VOLTAGE IMMEDIATELY
AFTER SOC SETTING

FIG. 5

```
                    ( START )
                        |
            ┌───────────────────────┐
            │        SET SOC        │ ─── S510
            └───────────────────────┘
                        |
            ┌───────────────────────┐
            │  STORE SOC SETTING DATA │ ─── S515
            └───────────────────────┘
                        |
            ┌───────────────────────┐
            │         AGING         │ ─── S520
            └───────────────────────┘
                        |
            ┌───────────────────────┐
            │      MEASURE OCV      │ ─── S530
            └───────────────────────┘
                        |
            ┌───────────────────────┐
            │         AGING         │ ─── S540
            └───────────────────────┘
                        |
            ┌───────────────────────┐
            │      MEASURE OCV      │ ─── S550
            └───────────────────────┘
                        |
            ┌───────────────────────┐
            │         AGING         │ ─── S560
            └───────────────────────┘
                        |
            ┌───────────────────────┐
            │      MEASURE OCV      │ ─── S570
            └───────────────────────┘
                        |
            ┌───────────────────────┐
            │   MEASURE IMPEDANCE   │ ─── S580
            └───────────────────────┘
                        |
            ┌───────────────────────┐
            │   CORRECT IMPEDANCE   │ ─── S585
            └───────────────────────┘
                        |
            ┌───────────────────────┐
            │ DIAGNOSE LOW-VOLTAGE CELL │ ─── S590
            └───────────────────────┘
                        |
                    (  END  )
```

FIG. 6

START

CALCULATE CORRECTION VALUE BASED ON DEVIATION
BETWEEN VOLTAGE MEASUREMENT VALUE IMMEDIATELY
AFTER SOC SETTING AND REFERENCE VALUE, AND IMPEDANCE — S610

CORRECT IMPEDANCE BASED ON IMPEDANCE,
CORRECTION VALUE AND CHARGING CAPACITY — S620

END

**TRANSLATION**

## INTERNATIONAL SEARCH REPORT

International application No.

**PCT/KR2025/012026**

### A. CLASSIFICATION OF SUBJECT MATTER

**G01R 31/389**(2019.01)i; **G01R 31/387**(2019.01)i; **G01R 31/396**(2019.01)i; **G01R 31/392**(2019.01)i; **G01R 31/367**(2019.01)i; **G01R 35/00**(2006.01)i; **G01R 19/165**(2006.01)i; **H02J 7/00**(2006.01)i

According to International Patent Classification (IPC) or to both national classification and IPC

### B. FIELDS SEARCHED

Minimum documentation searched (classification system followed by classification symbols)

G01R 31/389(2019.01); G01R 31/36(2006.01); G01R 31/374(2019.01); G01R 31/382(2019.01); H01M 10/44(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 배터리(battery), 방전(discharge), 저전압(low voltage), 불량(defect), SOC(state of charge), 임피던스(impedance), 보정(correction)

### C. DOCUMENTS CONSIDERED TO BE RELEVANT

| Category* | Citation of document, with indication, where appropriate, of the relevant passages | Relevant to claim No. |
|---|---|---|
| X | JP 2023-105941 A (DENSO CORP.) 01 August 2023 (2023-08-01)<br>see paragraphs [28], [31], [33], [35], [40], [44], [53]-[57], [61]. | 1-4,7-13,16 |
| A | | 5-6,14-15 |
| A | JP 2020-165859 A (NISSAN MOTOR CO., LTD. et al.) 08 October 2020 (2020-10-08)<br>see paragraphs [29]-[32], [49]-[52]. | 1-16 |
| A | KR 10-2649551 B1 (MINTECH CO., LTD.) 20 March 2024 (2024-03-20)<br>see paragraphs [5], [10], [37]-[49] and claims 1, 4. | 1-16 |
| A | JP 2006-215001 A (FUJI HEAVY IND. LTD.) 17 August 2006 (2006-08-17)<br>see claims 1-11. | 1-16 |
| A | KR 10-2011-0053001 A (POSCO) 19 May 2011 (2011-05-19)<br>see paragraphs [30]-[41]. | 1-16 |

☐ Further documents are listed in the continuation of Box C.  ☑ See patent family annex.

| | | |
|---|---|---|
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **07 November 2025** | **07 November 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

TRANSLATION

**INTERNATIONAL SEARCH REPORT**
**Information on patent family members**

International application No.

**PCT/KR2025/012026**

| Patent document cited in search report | | | Publication date (day/month/year) | Patent family member(s) | | | Publication date (day/month/year) |
|---|---|---|---|---|---|---|---|
| JP | 2023-105941 | A | 01 August 2023 | CN | 116466251 | A | 21 July 2023 |
| | | | | US | 2023-0231209 | A1 | 20 July 2023 |
| JP | 2020-165859 | A | 08 October 2020 | JP | 7165615 | B2 | 04 November 2022 |
| KR | 10-2649551 | B1 | 20 March 2024 | WO | 2025-135761 | A1 | 26 June 2025 |
| JP | 2006-215001 | A | 17 August 2006 | EP | 1688754 | A2 | 09 August 2006 |
| | | | | EP | 1688754 | A3 | 04 March 2009 |
| | | | | EP | 1688754 | B1 | 29 April 2015 |
| | | | | JP | 4638251 | B2 | 23 February 2011 |
| | | | | US | 2006-0176022 | A1 | 10 August 2006 |
| | | | | US | 7202632 | B2 | 10 April 2007 |
| KR | 10-2011-0053001 | A | 19 May 2011 | KR | 10-1105142 | B1 | 16 January 2012 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240136393